Europäisches Patentamt

European Patent Office

Office européen des brevets

(11) Publication number: **0 284 107**
**A2**

# EUROPEAN PATENT APPLICATION

(21) Application number: **88104932.4**

(22) Date of filing: **26.03.88**

(51) Int. Cl.⁴: **H01L 21/322** , **H01L 21/223** , **H01L 21/225** , **H01L 21/316**

(30) Priority: **27.03.87 JP 73441/87**

(43) Date of publication of application:
**28.09.88 Bulletin 88/39**

(84) Designated Contracting States:
**DE FR GB**

(71) Applicant: **Shin-Etsu Handotai Company, Limited**
**Togin Building 4-2, 1-chome, Marunouchi Chiyoda-ku Tokyo 100(JP)**

(72) Inventor: **Ito, Taizo**
**165-1, Gohara**
**Annaka-shi Gunma 379-01(JP)**
Inventor: **Masui, Tsumoru**
**165-1, Gohara**
**Annaka-shi Gunma 379-01(JP)**
Inventor: **Araki, Kenji**
**3-18-11, Annaka**
**Annaka-shi Gunma 379-01(JP)**
Inventor: **Watanabe, Masahide**
**406 Yanese Apartment Bldg. 117, Yanase**
**Annaka-shi Gunma 379-01(JP)**
Inventor: **Abe, Takao**
**477-19, Yanase**
**Annaka-shi Gunma 379-01(JP)**

(74) Representative: **Schneck, Herbert, Dipl.-Phys., Dr. et al**
**Rau & Schneck Patentanwälte Königstrasse 2**
**D-8500 Nürnberg 1(DE)**

(54) Method of strengthening silicon wafer.

(57) A method of strengthening a silicon wafer in which the wafer is doped with nitrogen. A silicon wafer on which a silicon oxide film has been formed on the surface thereof is subjected to heat treatment at a high temperature of 600 to 1300°C in a gas atmosphere consisting of a nitrogen or nitrogen compound gas, thereby doping the wafer with nitrogen. Thus, the method is capable of doping a silicon wafer with nitrogen with ease. Further, the method is capable of locking a lattice strain or crystallographic defects including a slippage or a dislocation which have occurred not only during the process of growing a silicon monocrystal but also during the formation of integrated circuit devices.

FIG.1

Xerox Copy Centre

## METHOD OF STRENGTHENING SILICON WAFER

### BACKGROUND OF THE INVENTION

Field of the Invention

The present invention relates to a method of strengthening a silicon wafer by doping it with nitrogen.

Description of the Prior Art

Integrated circuits on the surface of a silicon wafer are made by a series of processes including oxidation and diffusion processes in which the silicon wafer is treated at high temperatures of about 700 to 1250°C.

During such high temperature treatments of a silicon wafer, there is a risk that thermal stress generated within the silicon wafer may cause dislocations or other defects in it along with the warpage through deformation. The warpage adversely affects photoresist patterning, and the crystallographic defects deteriorate the performance of resulting integrated circuits as fabricated.

In order to avoid these problems, the process of preparing a monocrystal of silicon has been modified in such a manner that nitrogen is incorporated as dopant in it with a view to mechanically strengthen by the locking action of the nitrogen, thereby lessening the thermal stress influence on the wafers manufactured out of the monocrystal.

A silicon monocrystal doped with nitrogen has been obtained in the following manners.

If a silicon monocrystal is to be prepared by the Czochralski (CZ) method, a nitrogen gas or nitrogen compound gas such as ammonia is introduced along with a carrier gas into a pulling chamber in which is placed polycrystal silicon at a high temperature, thereby forming a film of silicon nitride ($Si_3N_4$) on the surface of the polycrystal silicon. Thereafter, the polycrystal silicon is melted, thereby allowing the nitrogen to be dissolved in the molten silicon, and then in the ordinary way a seed crystal is brought into contact with the melt and then pulled up, thereby obtaining a silicon monocrystal doped with nitrogen.

If a silicon monocrystal is to be prepared by the floating zone (FZ) method, a bar of polycrystal silicon is placed in an atmosphere of argon gas mixed with nitrogen gas, a zoning is proceeded by application and movement of induction heating, the nitrogen dissolves into the molten silicon, and a silicon monocrystal is formed with the nitrogen distributed uniformly in after solidification of the molten zone.

If a silicon monocrystal is to be prepared by the epitaxial growth method, during the epitaxial growth, nitrogen gas is introduced into the reactor as an ingredient in a carrier gas such as hydrogen, if necessary, together with dopant gas, to obtain a thin monocrystal film of silicon doped with nitrogen.

These methods, however, encounter the following problems. With the CZ method, since the segregation coefficient of the nitrogen is in the order of $10^{-3}$, if the solidification goes far almost to an end, for instance, at 90% of the melt, the nitrogen will be concentrated in the residual melt to ten times the initial concentration, and needle crystals of $Si_3N_4$ may frequently be deposited in the surface of the molten silicon, thereby disturbing crystallization. This means that, in order to prevent such disturbance, the initial amount of silicon nitride mixed with the molten silicon has to be limited low to an undesirable extent. Because of this limitation, a longer bar of silicon monocrystal shall be grown starting at an insufficient level of nitrogen doping.

With the CZ or epitaxial growth method, if the concentration of doped nitrogen is above $4.5 \times 10^{15}$ atom/cm$^3$, the monocrystal may not be properly grown. This means that both of these cannot achieve the objective of the present invention that is to strengthen silicon monocrystal with doped nitrogen thanks to the upper limit on crystallization.

In the manufacture of a DRAM having, for instance, a trench capacitor, a trench of, for instance, 20 μm in depth and 2 μm in diameter, may be formed by anisotropic reactive ion etching. During this process, crystal lattice strain is generated around the trench in thermal processes. Such crystal lattice strain may generate such crystallographic defects as slippage or dislocation or the like when the device is treated at high temperatures in the fabrication. These defects cannot be completely prevented solely by the doping of nitrogen during the growth of the monocrystal. Defects of these kinds affect more seriously the resulted performance of each component in trenched semiconductor integrated circuit devices with increase in packing density and decrease in a feature size.

The present invention has been accomplished on the basis of the following two findings discovered by the inventor.

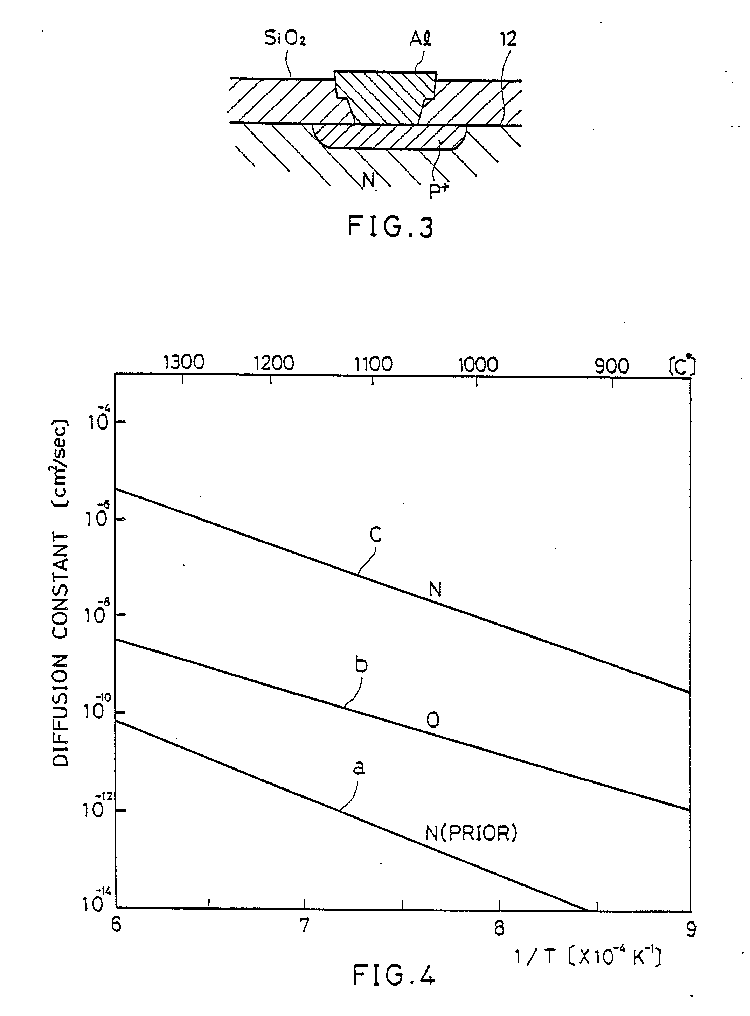

(1) Fig. 4 is a graph showing the diffusion constant of nitrogen in a silicon monocrystal as a function of temperature. The axis of abscissa represents the reciprocal of the absolute temperature T, while the axis of ordinate represents the diffusion constant.

The line (a) expresses the diffusion constant of nitrogen conventionally believed to be true. The diffusion constant of nitrogen along this line (a) is lower by a factor of about $10^2$ than the diffusion constant of oxygen expressed by the line (b). In this way, the conventional data has led us to a thought that, even if silicon wafers are placed in a nitrogen atmosphere, the wafers would not substantially be diffused with nitrogen into them.

However, the present inventors have found from the results of precise experiments conducted by them that the diffusion constant of nitrogen is in fact unexpectedly higher. That is, as indicated by the line (c) which expresses the diffusion constant of nitrogen obtained by the present inventors, the diffusion constant of nitrogen is larger than the conventionally-believed values by a factor of as much as about $10^5$ and is larger than that of oxygen by a factor of about $10^3$.

(2) If a silicon wafer is treated at a high temperature in an atmosphere solely comprising a nitrogen or nitrogen compound gas, a film of $Si_3N_4$ is formed on the surface of the wafer, thereby roughening the surface. This is not desirable in regard to the fabrication of ICs.

It has been found by the inventors, however, that, if the high temperature treatment of the silicon wafer is performed after either an oxygen gas has been added to the atmosphere or a film of $SiO_2$ has been formed on the surface of the wafer, the surface will keep its integrity and at the same time the silicon wafer can be doped with nitrogen without difficulty.

The present invention has been accomplished on the basis of the findings stated above.

## SUMMARY OF THE INVENTION.

In view of the problems discussed above, it is an object of the present invention to provide a method of strengthening a silicon wafer by doping with nitrogen through thermal diffusion into the wafer to the extent higher than achievable by doping concurrently during crystal growth and making the nitrogen capable of locking such defects as slippage or dislocation and the like around trenched structures in the surface as they are not to extend during the process of fabricating semiconductor circuit devices on the wafer.

To this end, one aspect of the present invention provides a method of strengthening a silicon wafer which comprises: subjecting a silicon wafer to heat treatment at a high temperature of 600 to 1300°C in a gas atmosphere consisting of a nitrogen or nitrogen compound gas and an oxygen gas while part or all of the crystal surface is exposed, thereby forming a film of silicon oxide on the surface of the silicon wafer and, simultaneously, doping the silicon wafer with nitrogen through the film of silicon oxide.

Another aspect of the present invention provides a method of strengthening a silicon wafer which comprises: subjecting a silicon wafer already having a film of silicon oxide formed on the surface thereof to heat treatment at a high temperature of 600 to 1300°C in a gas atmosphere consisting of a nitrogen or nitrogen compound gas, thereby doping the silicon wafer with nitrogen.

The method in accordance with the present invention provides the following effects. First, since doping with nitrogen is effected in the state of a silicon wafer, the crystal is naturally free from disturbances attributing to growth and, deterioration in crystallinity does not absolutely occur exposing it to the excessive nitrogen in a gas atmosphere at a high temperature to facilitate the sufficient doping.

In addition, since nitrogen diffuses within the silicon monocrystal at a relatively high rate, the doping can be performed within a short time.

Further, any defects including slippage and dislocation and the like which may be produced specially around trenched structures or often in the other area of the surface can be locked where they are not to propagate and degrade components in larger area by the action of nitrogen, which in short strengthens the relevant portions of the wafer.

## BRIEF DESCRIPTION OF THE DRAWINGS

Fig. 1 is a schematic illustration of the structure of a furnace for doping a silicon wafer with nitrogen, to which an embodiment of the present invention is applied:

Fig. 2 is a greatly enlarged sectional view of a trench formed in the surface of a silicon wafer;

Fig. 3 is a fragmentary sectional view of a semiconductor chip in a silicon wafer which is used for explanation of another embodiment of the present invention; and

Fig. 4 is a graph showing the diffusion constants of nitrogen and oxygen in a silicon monocrystal.

## DESCRIPTION OF THE PREFERRED EMBODIMENTS

Certain embodiments of the present invention will be described hereunder with reference to the accompanying drawings.

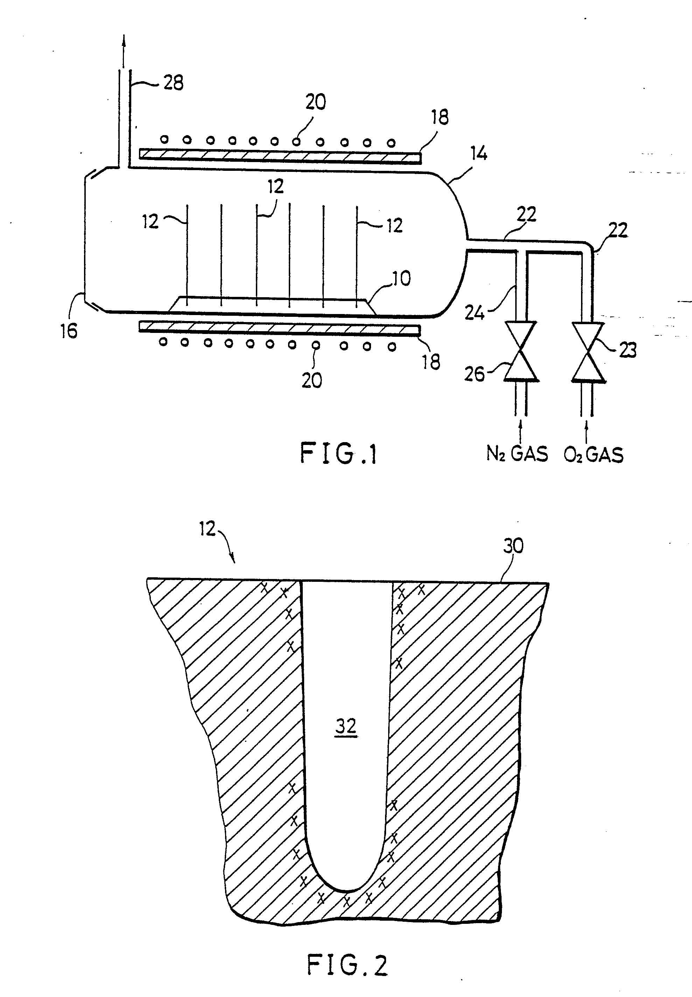

Fig. 1 illustrates a furnace for doping a silicon wafer with nitrogen.

A plurality of parallel grooves are formed in the upper surface of a quartz boat 10, and they each receive the lower end portion of a silicon wafer 12.

The quartz boat 10 with the silicon wafers 12 arranged in this condition, is shoved into a nitrogen doping quartz glass tube 14 through an opening thereof provided at the left end, as viewed in Fig. 1. This opening is closed by a cap 16 thereafter.

The nitrogen doping quartz glass tube 14 is surrounded by a pipe 18 to diminish temperature fluctuations, and an electrical wire 20 which serves as a heater is wound around the outer peripheral surface of the pipe 18.

An inlet pipe 22 is connected to the right end of the nitrogen doping quartz glass tube 14. A flow rate adjusting valve 23 is equipped in the inlet pipe 22 to supply oxygen gas into the nitrogen doping quartz glass tube 14 through them. A second inlet pipe 24 branches from the first inlet pipe 22, and a valve 26 is equipped in the second inlet pipe 24 to supply nitrogen gas into the nitrogen doping quartz glass tube 14 through them.

The oxygen and nitrogen gases will form the atmosphere within the nitrogen doping quartz glass tube 14 and they will be discharged to the outside through an outlet pipe 28 connected to the upper left portion of the tube 14.

The silicon wafers 12 have each been prepared for use in manufacture of, for instance, a DRAM having a trench capacitor, and they each have on the surface 30 thereof a trench 32 which serves as a three dimensional fine structure, as shown in Fig. 2. The trench 32 has been formed by an anisotropic reactive ion etching process employing a patterned silicon oxide mask with an opening which exposes a portion of the underlying surface and a $CCl_4$ gas. The diameter and the depth of the trench 32 are, for instance, 2 $\mu$m and 20 $\mu$m, respectively.

Crystal strain is newly generated after this dry-etching at the corners at the intersection of the surface 30 and the walls of the trench 32 and at the bottom, e.g., at the portion indicated by symbols X. In addition, crystallographic defects remain as they were in the crystal or will be often generated in the fabrication of integrated circuit devices on the wafer. In consequence, if the wafer which is in this condition is subjected to heat treatment at a temperature of about 700 to 1250°C, there is the great risk that the crystal strain and the crystallographic defects may lead to occurrence of various defects or grow further owing to the thermal stress, thereby deteriorating the component produced including the trench or not including it on the surface 30 of the wafer 12. Such risk, therefore, inevitably limits the increase in the integration density that is possible by making the trench 32 narrower and deeper.

The method in accordance with one embodiment of the present invention which is applied to the doping furnace constructed as described above will now be explained.

In Fig. 1, the heater 20 is turned on to heat the nitrogen doping quartz glass tube 14 to a temperature of about 600 to 1300°C, preferably to a temperature of about 1000°C. The flow rate control valve 23 and the valve 26 are opened to supply an oxygen gas and a nitrogen gas, respectively, into the interior of the tube 14.

The concentration of oxygen in the atmosphere within the nitrogen doping tube 14 is determined depending on the temperature within the tube 14, the period during which the oxygen gas is supplied to the tube 14, and the desired thickness of a $SiO_2$ film on the wall and bottom surface of the trench 32. The opening of the flow rate adjusting valve 23 is adjusted to determine oxygen concentration.

The concentration of nitrogen in the atmosphere within the tube 14 is determined depending on the temperature of the tube 14, the period during which the nitrogen gas is supplied to the tube 14, and the thickness as well as the quality of the $SiO_2$ film. In contrast with the method of doping silicon with nitrogen during the growth of a silicon monocrystal, the method of the present invention makes the concentration of nitrogen to be limitted by no upper limit. For the purpose of controlling doping level, the valve 26 is simply opened for supplying nitrogen, and there is no need to use a flow rate adjusting valve for precise control of nitrogen concentration in the atmosphere. Although the flow rate of nitrogen gas varies in accordance with the doping level required, if a furnace of a standard size is used, the flow rate is usually about 1 to 20 l/min, and the period is usually about 1 to 10 minutes.

In this way, a $SiO_2$ film is formed on the wall and bottom surface of the trench 32 of a silicon wafer 12, while nitrogen penetrates into the silicon wafer through this film and part of the nitrogen is trapped at portions where there are strains and crystallographic defects, for instance, dislocations, thereby hardening these portions against plastic deformation by its locking action. It is considered that nitrogen is trapped and $Si_3N_4$ is formed. By virtue of the strengthening of the silicon wafer, the wafer can be prevented from becoming deformed during the subsequent heat treatment.

Part of the nitrogen which is not trapped is distributed uniformly within the silicon wafer 12.

The valves 23 and 26 should be operated in such a manner that the valve 23 is opened in advance of the opening of the valve 26, so that no $Si_3N_4$ film is formed before the formation of the $SiO_2$ film. In the valve closing operation, either the valve 26 or the valve 23 may be closed first.

A second embodiment of the present invention will now be described with reference to Fig. 3.

An N-type silicon wafer 12 has integrated circuit devices formed on the surface thereof. That is, a p + layer has been formed by thermally diffused boron through a patterned SiO₂ mask overlying the silicon wafer 12, and Al is deposited over the mask including an opening in the SiO₂ film at a location above the p+ layer. The interface of the p+ layer and the deposited Al and the junction of the N-type substrate and the p+ layer are usually stressed and often include a variety of crystallographic defects such as dislocations as typical. The stress and defects tend to develop to defects or grow further respectively during heat treatment. To prevent such problems in the further progress of integrated circuit fabrication, the silicon wafer 12 should be doped with nitrogen. This doping is performed in the same manner as that of the first embodiment, except that, in this second embodiment, only a nitrogen gas is supplied to the inside of the nitrogen doping tube 14 since the SiO₂ layer is already formed on the surface of the silicon wafer 12. The thus supplied nitrogen disperses around and at the above-mentioned junction or interface.

In each of the foregoing embodiments, the nitrogen gas may be substituted by a nitrogen compound gas such as ammonia.

The SiO₂ film is not limited to a film formed by thermal oxidation, and it may alternatively be an oxide film formed by the CVD method. Needless to say, the SiO₂ film may be either a field oxide film or a gate oxide film.

Even if a Si₃N₄ film is formed on the surface of the silicon wafer, the silicon wafer can be doped with nitrogen through this film provided that this film is very thin.

**Claims**

1. A method of strengthening a silicon wafer which comprises: subjecting a silicon wafer to heat treatment at a high temperature of 600 to 1300°C in a gas atmosphere consisting of a nitrogen or nitrogen compound gas and an oxygen gas while part or all of the crystal surface is exposed, thereby forming a film of silicon oxide on said silicon wafer and, simultaneously, doping said silicon wafer with nitrogen through said film of silicon oxide.

2. A method of strengthening a silicon wafer according to claim 1, wherein said silicon wafer has an active region which is formed with various junctions or interfaces that form integrated circuit devices.

3. A method of strengthening a silicon wafer according to claim 1, wherein said silicon wafer has an active region which is formed with a flat surface portion or a three dimensional fine structure that forms an integrated circuit device.

4. A method of strengthening a silicon wafer according to claim 1, wherein said nitrogen compound gas is ammonia.

5. A method of strengthening a silicon wafer which comprises: subjecting a silicon wafer already having a film of silicon oxide formed on the surface thereof to heat treatment at a high temperature of 600 to 1300°C in a gas flow consisting of a nitrogen or nitrogen compound gas, thereby doping said silicon wafer with nitrogen.

6. A method of strengthening a silicon wafer according to claim 5, wherein said silicon wafer has an active region which is formed with various junctions or interfaces that form integrated circuit devices.

7. A method of strengthening a silicon wafer according to claim 5, wherein said silicon wafer has an active region which is formed with a flat surface portion or a three dimensional fine structure that forms an integrated circuit device.

8. A method of strengthening a silicon wafer according to claim 5, wherein said nitrogen compound gas is ammonia.

9. A method of strengthening a silicon wafer according to claim 5, wherein said film of silicon oxide is a film formed by thermal oxidation or an oxide film formed by the CVD method, used as a field oxide film or a gate oxide film.

FIG.1

N₂ GAS   O₂ GAS

FIG.2

FIG.3

FIG.4